(19) Europäisches Patentamt / European Patent Office / Office européen des brevets

(11) **EP 3 242 138 A1**

(12) **EUROPEAN PATENT APPLICATION**
published in accordance with Art. 153(4) EPC

(43) Date of publication:
**08.11.2017 Bulletin 2017/45**

(51) Int Cl.:
**G01R 31/02** *(2006.01)*

(21) Application number: **15875718.7**

(86) International application number:
**PCT/KR2015/014492**

(22) Date of filing: **30.12.2015**

(87) International publication number:
**WO 2016/108624 (07.07.2016 Gazette 2016/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.12.2014 KR 20140195574**

(71) Applicant: **Hyosung Corporation**
**Seoul 04144 (KR)**

(72) Inventors:
• **OH, Jae Hoon**
  **Incheon 21451 (KR)**
• **SEO, Jae Jin**
  **Uiwang-si**
  **Gyeonggi-do 16017 (KR)**

(74) Representative: **Viering, Jentschura & Partner mbB**
**Patent- und Rechtsanwälte**
**Am Brauhaus 8**
**01099 Dresden (DE)**

(54) **METHOD FOR DIAGNOSING STATE OF CAPACITOR IN MODULAR CONVERTER**

(57) The present invention relates to a method for diagnosing the state of the capacitor in a modular converter.

The method for diagnosing the state of the capacitor in a modular converter includes determining a FIT table depending on the input voltage and temperature of an internal capacitor for multiple sample modular converters; detecting, by an input voltage detection unit, the input voltage of the capacitor in a target modular converter, the state of the capacitor of which is to be diagnosed, during a preset period; detecting, by a temperature detection unit, the temperature of the capacitor of the target modular converter during the preset period; calculating the cumulative mean for the input voltage and the temperature, which are respectively detected by the input voltage detection unit and the temperature detection unit during the preset period; and selecting, by a control unit, a FIT value corresponding to the cumulative mean of the input voltage and the temperature, from the FIT table; and extracting the MTBF of the capacitor from the FIT table.

FIG.1

## Description

## Technical Field

The present invention relates, in general, to a method for diagnosing the state of a capacitor and, more particularly, to a method for diagnosing the state of a capacitor in a modular converter, in which the Mean Time Between Failures (MTBF) of a capacitor in a modular converter is extracted using the cumulative mean of the input voltage and the temperature of the capacitor, whereby the state of the corresponding capacitor is diagnosed.

## Background Art

Recently, power systems have been greatly changed with new forms of renewable energy and emphasis on the quality of power, and such changes increase the need for devices such as High-Voltage Direct Current (HVDC) systems or Static Synchronous Compensator (STATCOM) devices.

Recently, a modular configuration is newly applied to converters for HVDC systems or converters for STATCOM devices. Specifically, an HVDC system or a STATCOM device is not configured using a single converter having a large capacity but is configured such that modular converters, each having a small capacity, are connected in series so as to make a large system.

In modular converters, expensive passive elements, such as high-capacity capacitors or discharge resistors, are used, and the lifespan of the device itself is determined by these elements, but it is difficult to actively determine the state thereof due to the characteristics of these passive elements.

Generally, the state of a capacitor may be checked through regular maintenance, but because heat generated in a modular converter when the system operates, and vibration, shock, dust and the like, generated near the device during the operation may degrade the performance of elements, technology for detecting the states of these elements during the operation thereof is required.

To this end, Japanese Patent No. 4011016 discloses technology in which a device for measuring voltage, current, and ambient temperature is installed in a power apparatus to which a capacitor is applied, capacitance is acquired from the result of the measurements acquired using the device, and the remaining life of the capacitor is determined using the capacitance. However, in Japanese Patent No. 4011016, it is necessary to additionally consider the internal resistance of the capacitor, but because the internal resistance frequently changes depending on the environment in which the capacitor is used, it is difficult to accurately determine the remaining life of the capacitor.

In order to compensate for this, Korean Patent No. 10-1133478 provides a device for diagnosing the remaining life of a capacitor, in which the remaining life of a battery device, constituted by a capacitor, is diagnosed in the state in which the discharge time period, for which the battery device can perform discharge while outputting rated power or power required by a load, exceeds a rated compensation time period required depending on each power compensation device (i.e. the time period for which the rated power can be output). However, it is disadvantageous in that the life of the battery device is determined only when the discharge time period exceeds the rated compensation time period.

Additionally, a technique for diagnosing the life of a condenser depending on the charging time thereof and the characteristics of a charging voltage (Japanese Patent No. 4812368) and a technique for diagnosing the life of a condenser depending on the temperature of the DC electrolytic condenser and charging/discharging current (Japanese Patent Application Publication No. 1995-092213) are disclosed. However, the former has low reliability because temperature, which affects the life of a capacitor, is not considered in the determination, and the latter is problematic in that it is difficult to accurately reflect the actual temperature of a capacitor because the internal temperature of the condenser is calculated using an equation.

## Disclosure

## Technical Problem

An object of the present invention is to provide a method for diagnosing the state of a capacitor in a modular converter, in which, in order to diagnose the state of a capacitor applied to a modular converter, the input voltage and temperature of the capacitor are measured, and the MTBF is calculated using the cumulative mean of the measurements, whereby the state of the capacitor may be diagnosed.

## Technical Solution

A method for diagnosing a state of a capacitor in a modular converter according to an embodiment of the present invention includes setting a Failures in Time (FIT) table depending on an input voltage and a temperature of an internal capacitor for multiple sample modular converters; detecting, by an input voltage detection unit, an input voltage of a capacitor in a target modular converter, a state of the capacitor of which is to be diagnosed, during a preset period; detecting, by a temperature detection unit, a temperature of the capacitor of the target modular converter during the preset period; calculating a cumulative mean for the input voltage and the temperature, which are respectively detected by the input voltage detection unit and the temperature detection unit during the preset period; selecting, by a control unit, a FIT value, corresponding to the calculated cumulative mean for the input voltage and temperature, from the FIT table;

and extracting a Mean Time Between Failures (MTBF) of the capacitor from the FIT value.

In the present invention, the setting the FIT table includes determining a FIT value based on an input voltage and a temperature of the capacitor for each of the multiple sample modular converters; generating a FIT graph from the determined FIT value for each of the multiple sample modular converters; and setting the FIT table by extracting a FIT value, corresponding to preset ranges of the input voltage and temperature, from the FIT graph.

In the present invention, the extracting the MTBF includes calculating a failure rate ($\lambda$) for the multiple sample modular converters using ($N = N_0 \times e^{-\lambda t}$); and extracting the MTBF from the failure rate ($\lambda$) and the FIT value, using (MTBF = $\lambda \times$ FIT value).

In the present invention, after the extracting the MTBF, generating a warning sound when a failure occurrence time, predicted based on the extracted MTBF of the capacitor, arrives is further included.

**Advantageous Effects**

According to the present invention, in the case of a modular converter applied to an HVDC system or a STATCOM device, because a high voltage is input thereto, this input voltage and a temperature are measured, and the MTBF is acquired using the cumulative mean of each of the measurements, whereby the reliability of diagnosis of the state of a capacitor may be improved.

Also, according to the present invention, because the MTBF for the capacitor in a modular converter is calculated, the maintenance time for the capacitor may be accurately predicted.

**Description of Drawings**

FIG. 1 is a block diagram of the apparatus for diagnosing the state of a capacitor in a modular converter according to the present invention;

FIG. 2 is a graph for describing the process of generating Failures In Time (FIT) according to the present invention; and

FIG. 3 is a flowchart illustrating the method for diagnosing the state of a capacitor in a modular converter according to the present invention.

**Best Mode**

Hereinafter, some embodiments of the present invention will be described in detail with reference to exemplary drawings. Reference should now be made to the drawings, in which the same reference numerals are used throughout the different drawings to designate the same or similar components. In the following description, it is to be noted that, when the functions of conventional elements and the detailed description of elements related with the present invention may make the gist of the present invention unclear, a detailed description of those elements will be omitted.

It will be understood that, although the terms "first," "second," "A," "B," "(a)," "(b)," etc. may be used herein to describe various elements, these terms are only used to distinguish one element from another element, and the essentials or the order of these elements should not be limited by these terms. When a first element is described as being "connected," "combined," or "coupled" to a second element, it should be understood that the first element may be directly connected or coupled to the second element, or that another element may alternatively be "connected," "combined" or "coupled" therebetween.

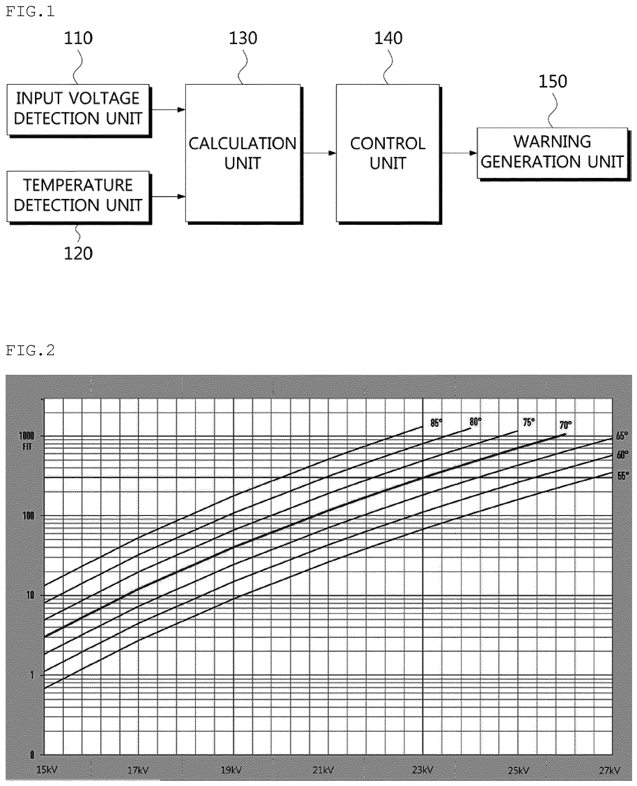

FIG. 1 is a block diagram of an apparatus for diagnosing the state of a capacitor in a modular converter according to an embodiment of the present invention.

Referring to FIG. 1, a modular converter according to an embodiment of the present invention may be applied to, for example, an HVDC system or a STATCOM device. In this case, the modular converter is supplied with a high voltage and stores the same in the internal capacitor thereof. Because the state of such a capacitor is changed depending on the input voltage and the temperature, an object of the apparatus for diagnosing the state of a capacitor according to the present invention is to diagnose the state of the capacitor.

To this end, the apparatus for diagnosing the state of a capacitor in a modular converter according to the present embodiment is configured to include an input voltage detection unit 110 for detecting the voltage input to the capacitor, a temperature detection unit 120, installed so as to be in contact or not in contact with the capacitor, for detecting the temperature of the capacitor, a calculation unit 130 for receiving the input voltage and the temperature, respectively detected by the input voltage detection unit 110 and the temperature detection unit 120, cumulatively adding the received input voltage and temperature during a preset time period, and calculating the cumulative mean of the cumulatively added values, and a control unit 140 for extracting an MTBF from the cumulative mean.

The input voltage detection unit 110 detects the input voltage, which is input to the capacitor from the front thereof. Here, the input voltage means the magnitude of the voltage supplied to the capacitor, which is different from the charging voltage of the capacitor. Also, the temperature detection unit 120 detects the temperature of the capacitor while in contact with the capacitor, or alternatively detects the temperature of the capacitor or the ambient temperature without being in contact therewith.

Here, in order to extract the MTBF of the capacitor from the cumulative mean of the input voltage and temperature, the present invention uses a Failure In Time (FIT) table for a modular converter. The FIT table is a table in which FIT values are defined based on the temperature and input voltage of a capacitor in a modular converter, which is the same product as the modular converter, the state of the capacitor of which is to be diagnosed. Here, a FIT value is a value that defines the time at which a failure occurs in the capacitor of the corresponding modular converter. That is, it is the fault occurrence time based on the temperature and input voltage of the capacitor of a modular converter. This FIT table may be determined based on reliable data on capacitor products produced by a manufacturer. Alternatively, in another example, the temperature and input voltage are measured through multiple experiments targeted at a plurality of the same modular converter products, and the time at which a fault occurs is measured based on the measured values, whereby the FIT table based on the temperature and input voltage of a capacitor of the corresponding modular converter may be determined.

Therefore, in the method for diagnosing the state of a capacitor in a modular converter according to the present invention, a FIT table for the modular converter, the state of the capacitor of which is to be diagnosed, is prepared in advance, and a FIT value is extracted by applying the cumulative mean of the temperature and input voltage of the capacitor of the corresponding modular converter to the FIT table, whereby the MTBF corresponding to the FIT value is extracted. Here, the Mean Time Between Failures (MTBF) is the arithmetic mean time between failures when a component, a device, or a system operates, and means the mean interval between failures. This MBTF is one of the indicators for representing how reliable a component, a device, or a system is, and the higher the MBTF, the higher the reliability.

Meanwhile, the present embodiment may further include a warning generation unit 150, and the warning generation unit 150 determines whether a fault occurrence time, predicted based on the MTBF of the capacitor, extracted by the control unit 140, has arrived, and generates a warning sound when the fault occurrence time arrives. This is intended to prompt the performance of preventive repairs, replacement, or inspection via the warning sound when the fault occurrence time, predicted based on the MTBF of the capacitor, arrives.

FIG. 2 is a graph for describing the process of generating a FIT table according to the present invention.

Referring to FIG. 2, in order to generate a FIT table according to the present invention, multiple sample modular converters are arranged, and a FIT value is determined based on the temperature and input voltage of the capacitor for each of the sample modular converters. Here, the larger the number of sample modular converters, the more reliable the FIT table. The FIT graph is generated from the FIT values for the sample modular converters using a program. In the present embodiment, the control unit 140 generates a 2-dimensional graph, the X axis and the Y axis of which are the input voltage and temperature, from the multiple FIT values using a predetermined program. Using this graph, a FIT table is generated based on the range of the temperature and input voltage. FIG. 2 shows an example of the FIT table in which the temperature ranges from 55 to 85° and the input voltage ranges from 15 to 27kV. These ranges may be changed depending on the capacity of the capacitor to be measured.

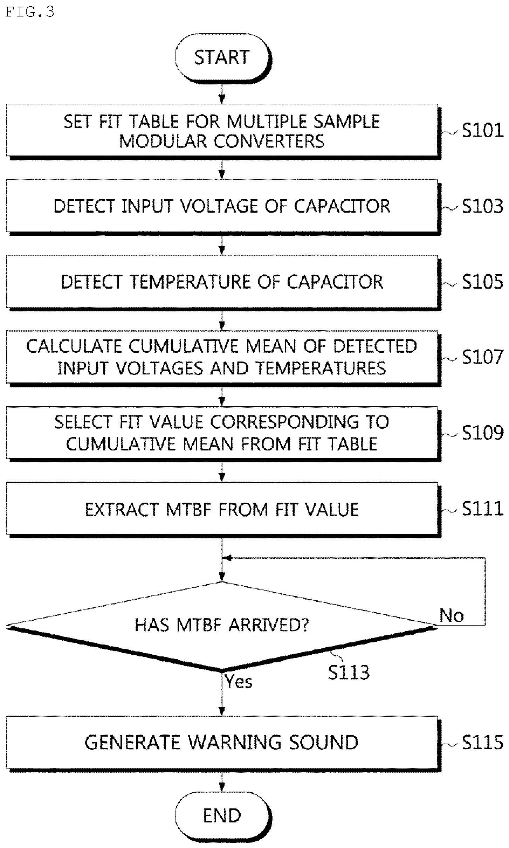

FIG. 3 is a flowchart illustrating the method of diagnosing the state of a capacitor in a modular converter according to the present invention.

Referring to FIG. 3, the method for diagnosing the state of a capacitor in a modular converter according to the present invention intends to diagnose the state of a capacitor of a modular converter that is applied to, for example, an HVDC system or a STATCOM device. First, a FIT table is set depending on the input voltage and temperature of capacitors of multiple sample modular converters at step S101. That is, as described above, a FIT value depending on the input voltage and temperature of a capacitor is determined for each of the multiple sample modular converters, and the FIT graph is generated from the FIT value for each of the sample modular converters. When the FIT table is set, the input voltage detection unit 110 measures the input voltage of a capacitor of a target modular converter, the state of the capacitor of which is to be diagnosed, at preset regular intervals at step S103, and the temperature detection unit 120 measures the temperature of the capacitor to be diagnosed at the preset regular intervals at step S105. Here, steps S103 and S105 may be performed in an arbitrary order, or they may be performed in the same time.

Subsequently, the calculation unit 130 calculates the cumulative mean of the multiple values, acquired by measuring the input voltage and temperature at the preset regular intervals at step S107. The cumulative mean is the arithmetic mean of the input voltage and the temperature, which are measured and cumulatively added at a preset regular interval. Then, at step S109, the control unit 140 selects the FIT value corresponding to the cumulative mean from the FIT table, which is set at step S101. Subsequently, the control unit 140 extracts the MTBF of the capacitor from the selected FIT value at step S111. Then, whether a fault occurrence time, predicted from the extracted MTBF of the capacitor, has arrived is determined at step S113. Here, when it is determined that the fault occurrence time has arrived, a step of generating a warning sound (S115) may be further included. This serves to prompt for the performance of operations such as preventive repairs, replacement, inspection, or the like via the warning sound when a fault occurrence time, predicted based on the extracted MTBF, arrives while the capacitor is in use.

Hereinafter, the process of extracting an MTBF is described. In an embodiment of the present invention, a failure rate ($\lambda$) for the multiple sample modular converters is calculated. The failure rate ($\lambda$) is calculated using the following Equation 1:

[Equation 1]

$$N = N_0 \times e^{-\lambda t}$$

where $N_0$ denotes the number of multiple sample modular converters, $N$ denotes the number of modular converters that remain in a normal state after an experiment, $\lambda$ denotes the failure rate, and $t$ denotes the experiment time.

The failure rate $\lambda$ may be calculated using the number of modular converters that remain in a normal state without a fault after a preset time $t$ has passed, among the multiple sample modular converters. An MTBF is extracted from the calculated failure rate $\lambda$ and the selected FIT value, using the following Equation 2:

[Equation 2]

$$\text{MTBF} = \lambda \times \text{FIT value}$$

The calculated MTBF becomes the criterion for determining how often a fault occurs, on average, in the capacitor of the corresponding modular converter. Therefore, in the present invention, the current state of the capacitor may be diagnosed using the MTBF, and when a fault occurrence time, predicted based on the MTBF, arrives, a process such as maintenance, inspection, or replacement is performed, whereby an accident that may arise from the fault of the capacitor in the modular converter may be prevented in advance.

As described above, although all components constituting an embodiment of the present invention have been described as being combined into one element or being operated as a single unit, the present invention is not limited thereto. That is, all components may be selectively combined into one or more components and operated. Also, the terms such as "include," "comprise," or "have" specify the presence of the stated element but do not preclude the addition of one or more other elements unless otherwise specified. Unless differently defined, all terms used here including technical or scientific terms have the same meanings as the terms generally understood by those skilled in the art to which the present invention pertains. The terms identical to those defined in generally used dictionaries should be interpreted as having meanings identical to contextual meanings of the related art, and are not interpreted as having ideal or excessively formal meanings unless they are definitely defined in the present specification.

The above description is merely an illustration of the technical spirit of the present invention, and those having ordinary knowledge in the technical field to which the present invention pertains can make modifications and variations within the range that does not depart from the essential characteristics of the present invention. Accordingly, the disclosed embodiments of the present invention are not intended to limit the technical spirit of the present invention but to illustrate the technical spirit of the present invention, and the scope of the technical spirit of the present invention is not limited to these embodiments. The range of protection of the present invention should be interpreted based on the following claims, and all technical spirit within the range equivalent to the claims should be construed as falling within the range of the rights of the present invention.

**Claims**

1. A method for diagnosing a state of a capacitor in a modular converter, comprising:

   setting a Failures in Time (FIT) table depending on an input voltage and a temperature of an internal capacitor for multiple sample modular converters;
   detecting, by an input voltage detection unit, an input voltage of a capacitor in a target modular converter, a state of the capacitor of which is to be diagnosed, during a preset period;
   detecting, by a temperature detection unit, a temperature of the capacitor of the target modular converter during the preset period;
   calculating a cumulative mean for the input voltage and the temperature, which are respectively detected by the input voltage detection unit and the temperature detection unit during the preset period;
   selecting, by a control unit, a FIT value, corresponding to the calculated cumulative mean for the input voltage and temperature, from the FIT table; and
   extracting a Mean Time Between Failures (MTBF) of the capacitor from the FIT value.

2. The method of claim 1, wherein the setting the FIT table comprises:

   determining a FIT value based on an input voltage and a temperature of the capacitor for each of the multiple sample modular converters;
   generating a FIT graph from the determined FIT value for each of the multiple sample modular converters; and
   setting the FIT table by extracting a FIT value, corresponding to preset ranges of the input voltage and temperature, from the FIT graph.

3. The method of claim 1, wherein the extracting the MTBF comprises:

   calculating a failure rate ($\lambda$) for the multiple sample modular converters using ($N=N_0 \times e^{-\lambda t}$); and
   extracting the MTBF from the failure rate ($\lambda$) and the FIT value, using (MTBF = $\lambda \times$ FIT value).

**EP 3 242 138 A1**

**4.** The method of claim 1, further comprising after the extracting the MTBF, generating a warning sound when a failure occurrence time, predicted based on the extracted MTBF of the capacitor, arrives.

FIG.1

110   130   140

```
┌──────────────┐      ┌──────────────┐      ┌──────────────┐
│ INPUT VOLTAGE│      │              │      │              │
│ DETECTION UNIT│─────▶│ CALCULATION  │─────▶│   CONTROL    │
└──────────────┘      │    UNIT      │      │    UNIT      │
                      │              │      │              │
┌──────────────┐      │              │      └──────────────┘
│ TEMPERATURE  │─────▶│              │
│DETECTION UNIT│      └──────────────┘
└──────────────┘
```

150

```
┌──────────────────┐
│     WARNING      │
│ GENERATION UNIT  │
└──────────────────┘
```

120

FIG.2

7

FIG.3

START

SET FIT TABLE FOR MULTIPLE SAMPLE MODULAR CONVERTERS ~ S101

DETECT INPUT VOLTAGE OF CAPACITOR ~ S103

DETECT TEMPERATURE OF CAPACITOR ~ S105

CALCULATE CUMULATIVE MEAN OF DETECTED INPUT VOLTAGES AND TEMPERATURES ~ S107

SELECT FIT VALUE CORRESPONDING TO CUMULATIVE MEAN FROM FIT TABLE ~ S109

EXTRACT MTBF FROM FIT VALUE ~ S111

HAS MTBF ARRIVED? No S113

Yes

GENERATE WARNING SOUND ~ S115

END

## INTERNATIONAL SEARCH REPORT

| International application No. |
|---|
| **PCT/KR2015/014492** |

### A. CLASSIFICATION OF SUBJECT MATTER

**G01R 31/02(2006.01)i**

According to International Patent Classification (IPC) or to both national classification and IPC

### B. FIELDS SEARCHED

Minimum documentation searched (classification system followed by classification symbols)
G01R 31/02; G01R 31/00; H02H 7/16; H02J 7/00; G01R 27/02; H01G 11/00; H01G 13/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: converter, capacitor, diagnosis, temperature, state

### C. DOCUMENTS CONSIDERED TO BE RELEVANT

| Category* | Citation of document, with indication, where appropriate, of the relevant passages | Relevant to claim No. |
|---|---|---|
| Y | JP 2005-168261 A (TOSHIBA CORP.) 23 June 2005<br>See paragraph [0014] and claim 4. | 1,4 |
| A | | 2-3 |
| Y | KR 10-2011-0010101 A (MEIDENSHA CORPORATION) 31 January 2011<br>See abstract, paragraph [0175] and claim 1. | 1,4 |
| A | JP 2008-070296 A (POWER SYSTEM K.K.) 27 March 2008<br>See abstract, claims 1-3 and figures 5-6, 8. | 1-4 |
| A | JP 2008-268042 A (POWER SYSTEM K.K.) 06 November 2008<br>See claims 1, 3 and figures 1, 7-8. | 1-4 |
| A | JP 2004-037258 A (TOSHIBA CORP.) 05 February 2004<br>See abstract and figures 2, 15. | 1-4 |

☐ Further documents are listed in the continuation of Box C.  ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 11 APRIL 2016 (11.04.2016) | **11 APRIL 2016 (11.04.2016)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea<br>Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2015/014492**

| Patent document cited in search report | Publication date | Patent family member | Publication date |
|---|---|---|---|
| JP 2005-168261 A | 23/06/2005 | JP 4011016 B2 | 21/11/2007 |
| KR 10-2011-0010101 A | 31/01/2011 | CN 102057282 A | 11/05/2011 |
| | | CN 102057282 B | 17/04/2013 |
| | | EP 2290383 A1 | 02/03/2011 |
| | | EP 2290383 A4 | 22/10/2014 |
| | | JP 05131350 B2 | 30/01/2013 |
| | | KR 10-1133478 B1 | 10/04/2012 |
| | | US 08521459 B2 | 27/08/2013 |
| | | US 2011-0125436 A1 | 26/05/2011 |
| | | WO 2009-148160 A1 | 10/12/2009 |
| JP 2008-070296 A | 27/03/2008 | JP 3969734 B1 | 05/09/2007 |
| JP 2008-268042 A | 06/11/2008 | JP 4042917 B1 | 06/02/2008 |
| JP 2004-037258 A | 05/02/2004 | NONE | |

Form PCT/ISA/210 (patent family annex) (January 2015)

**REFERENCES CITED IN THE DESCRIPTION**

**Patent documents cited in the description**

- JP 4011016 B
- KR 101133478
- JP 4812368 B
- JP 7092213 A